# EUROPEAN PATENT SPECIFICATION

(11) **EP 4 214 439 B1**
(45) Date of publication and mention of the grant of the patent: **17.04.2024**
(21) Application number: 21777511.3
(22) Date of filing: 14.09.2021
(51) Int. Cl.: F21S 10/00, F21K 9/90, F21S 4/20, H05K 1/18, F21Y 115/10, F21Y 103/10, F21Y 105/16, F21Y 107/70

(54) **FOLDED LIGHTING DEVICE WITH LED ARRAY**
GEFALTETE BELEUCHTUNGSVORRICHTUNG MIT LED-ARRAY
DISPOSITIF D'ÉCLAIRAGE PLIÉ AVEC RÉSEAU DE DEL

(30) Priority: 17.09.2020 EP 20196680
(43) Date of publication of application: 26.07.2023
(73) Proprietor: Signify Holding B.V., 5656 AE Eindhoven (NL)
(72) Inventor: VAN DELDEN, Martinus, Hermanus, Wilhelmus, Maria, 5656 AE Eindhoven (NL); DE VRIES, Hendrikus, Johan, Adrie, 5656 AE Eindhoven (NL)
(74) Representative: Verweij, Petronella Daniëlle
(86) International application number: PCT/EP2021/075241
(87) International publication number: WO 2022/058310

(56) References cited:
- EP-A1- 3 094 161
- WO-A1-2015/058565
- US-A1- 2010 067 256

## Description

### FIELD OF THE INVENTION

The present invention relates to a lighting device including an array of LEDs mounted on a strip substrate. Such a lighting device may be useful in applications for providing a natural lighting effect.

### BACKGROUND OF THE INVENTION

An example of a natural lighting effect is the shadow dynamics of tree leaves moving in the wind which can be observed on projection surfaces (e.g. the ground) during a bright sunny day. It is important to note that even when the leaves are not observed directly, their dynamics is maintained in the movement of the shadows. Hence the observed shadows feel natural, comfortable and safe (at moderate to low wind speeds) even when the fine features and true colors of the leaves are not observed directly at the same time. So, on outdoor surfaces a natural feeling lighting effect may be observed, which lighting effect may be described as a combination of a larger group of less bright areas (the overlapping shadows of the individuals leaves) moving within a brighter field of diffuse and directional (sun)light.

Another example of a natural lighting effect comprising a different set of dynamics, colors and speed of change is an open fire. Similar to the previous, even when the fireplace is not observed directly, the resulting light experience presented via reflection on surfaces in the vicinity of the fire, feels familiar, comfortable, relaxing and natural.

Yet another example of a natural lighting effect are sparkles, for example arising from the reflection of the sun's rays at the wave peaks of water set in motion. Again, when the deflected light falls onto a surface, the light experience feels natural and calming although the sun and the waves are not observed directly. In other words, a light experience can already feel natural and comfortable without the need for an actual observation of the cause.

In some situations, it is desirable to (artificially) provide the positive effects of such natural lighting effects, also indoors and when no outdoor light is present. One option is to use conventional high-resolution displays and/or beamer devices, by which natural content (e.g. a fireplace) is displayed. However, if such a device or its projected image is not or is no longer observed directly, the feeling of a natural experience is rapidly lost. This is because the information retained in the far field only comprises of an average light intensity, colour and frequency of change. On the other hand, in case that the content is observed directly, the cognitive part of the human brain is immediately triggered to analyze that content (e.g. the fire) in further detail, therewith distracting for example office workers from their main tasks. On top of that, rich content can be subject to personal and cultural preferences, thereby potentially resulting in even larger distractions. The underlying natural dynamics and their beneficial effects, however, are typically universal and not bound to culture and/or religion.

Obviously, the challenges in avoiding cognitive image processing can be solved technically, for example by providing non-looped content based on the principles of nature, yet at sufficiently low-resolution. And, to enhance the experience even further, it may be provided as an immersive light experience rather than a (single) framed execution thereof. A challenge in immersive natural light experiences is that multiple large-sized (elongated) light areas may be required to yield an omnidirectional, 360 natural light, experience.

A further challenge in large-sized, pixelated light-areas is cost of pixelation. That is, the cost of addressable light nodes such as pixelated LED strips or matrix panels are relatively high and furthermore, cost of control components to drive these is also high. Moreover, when a large-sized (elongated) light-area is formed using a plurality of e.g. pixelated LED strips, for example, to at least provide an acceptable device resolution, the costs per unit area already skyrocket, in particular when medium to high-power, multi-colour light nodes are also to compete with ambient (day) light.

For the sake of clarity and reference, also note that although costs do not necessarily pose a barrier to the application of matrix addressable lighting devices, for example in the entertainment industry (e.g. high budget TV shows), similar devices are not deployed in office and hospitality areas simply because they are unaffordable.

Note, however, that as indicated above, high resolution images are not required to provide a natural lighting effect. What is required is that the lighting effect feels natural, comfortable and relaxing, i.e. the created content represents an abstract light experience comprising the appropriate set of dynamics, correct colour(s), resolution, intensity, relative intensity (ratios), frequency and frequency of change (ramp-up, ramp-down and hold, colour transition), etc. One known method to generate such (random) content is the use of Markov chains and mapping the generated image towards the matrix addressable light area.

In WO 2015/058565 a flexible circuit board is disclosed, including a first insulation layer, a second insulation layer and a circuit layer, wherein the first insulation layer is attached to one side of the circuit layer and the second insulation layer is attached to the other side of the circuit layer, each of the first insulation layer and the second insulation layer is provided with a foldable portion along their length, the foldable portion of the first insulation layer is corresponding in position with the foldable portion of the second insulation layer, and the circuit layer includes a set of power wires and at least one lighting wire. And a method for manufacturing the flexible circuit board, and a LED flexible strip light are also disclosed.

### SUMMARY OF THE INVENTION

It is an object of the present invention to provide a cost efficient and easily manufactured light engine suitable for creating a low-cost, large-area, pixelated light-area that can provide a natural lighting effect.

According to a first aspect of the invention, this and other objects are achieved by a folded light engine comprising an array of LEDs mounted on a strip substrate, wherein
the strip substrate comprises a central portion and first and second peripheral portions of substantially equal width and extending in parallel in the longitudinal direction of the strip substrate,
the central portion being provided with a first set of through-holes,
the first peripheral portion being provided with at least one electrically conducting track, connecting a first group of LEDs mounted on the first peripheral portion, each LED in the first group being aligned with a through-hole in the central portion,
the first peripheral portion further being provided with a second set of through holes, each through-hole in the second set being aligned with a through-hole in the first set,
the second peripheral portion being provided with at least one electrically conducting track, connecting a second group of LEDs mounted on the second peripheral portion, each LED in the second group being aligned with a through-hole in the first set and with a through-hole in the second set,
wherein the first peripheral portion has been folded over the central portion, so that the LEDs mounted on the first peripheral portion coincide with through-holes in the central portion, and through-holes in the first peripheral portion coincide with corresponding through-holes in the central portion, and
wherein the second peripheral portion has been folded over the first peripheral portion, so that LEDs mounted on the second peripheral portion coincide with a combined through-hole formed by a through-hole in the central portion and a through-hole in the first peripheral portion.

By the design and folding according to the invention, an elongated light engine can be cost efficiently manufactured from a strip substrate by means of relatively simple processes, including single-sided circuit patterning and LED mounting. The substrate may be made of a relatively low cost foil-type material. Due to the double folding, the resulting light engine will possess sufficient stiffness for most applications. The folding will also serve to shield and mechanically protect the LEDs and patterned circuits.

The LEDs connected by the different electrically conducting tracks form different LED-chains, which may be driven by a suitable drive signal to create a desired lighting effect. This makes the folded light engine very suitable to form part of a larger light area to be driven as discussed in the patent application titled "Lighting device for providing a natural lighting effect" filed on the same date as the present application.

More specifically, the LEDs of the folded light engine, which may belong to two, three or more separate LED chains, may be distributed randomly along the length of the substrate. By connecting one driver to each LED-chain, and controlling the drivers to provide different and dynamically changing drive signals, the desired lighting effect may be achieved. Preferably, several folded light engines, each with a random LED distribution, are arranged in parallel to form a larger light area, where LEDs belonging to at least three LED-chains are substantially evenly and non-symmetrically distributed.

The expression "substantially evenly distributed" is intended to mean that the LED light sources of each of the at least three LED chains are spread out across the entire light area and not e.g. gathered in a small portion of the light area.

The expression "non-symmetrically distributed" is intended to mean that the LED light sources of the at least three LED chains are distributed and mixed (between the different chains) together in a seemingly random pattern, and not e.g. in a regular pattern.

By distributing the LEDs of the three LED chains in a substantially even and non-symmetrical manner across the light area, three groups of more or less randomly distributed LEDs may be controlled independently of each other. By applying different, and dynamically changing drive signals to the three groups, lighting effects resembling those occurring in nature can be accomplished, at a fraction of the costs of a pixelated and addressable device. The invention thus provides a lighting experience which is similar to that caused by a natural lighting effect as discussed above, in a cost-efficient manner.

In order to even better shield and protect the LEDs (and electrically conductive circuit tracks) the substrate portions may, in the folded state, be attached, and optionally sealed, to each other.

The light engine may further include an additional peripheral portion, outside the second peripheral portion, said additional peripheral portion being configured to be folded onto the backside of the central portion.

Optionally, a protecting sleeve may be arranged to enclose the folded substrate, to provide even more sealing and protection. The space between such an outer sleeve and the folded substrate may be filled with a curable filler. The filler may be configured to form a mechanical barrier or an optical component. For example, the filler may be optically transparent. The sleeve may be a separate component, arranged around the substrate after it has been folded (and optionally sealed).

Alternatively, the protective sleeve is formed by a light transparent foil, wrapped around the folded light engine.

Several identical folded light engines (possibly with different distribution of LEDs) can advantageously be formed in one common substrate. The central portions of each such light engine may then be connected by a transversal portion of the substrate. The transversal portion may be provided with electrically conductive tracks, which connect the conductive tracks of the respective light engines in parallel. Such a multi-light-engine device will thus include several elongated light engines and may advantageously serve a (part of) a larger light area.

A second aspect of the invention relates to a lighting device comprising at least one folded light engine according to the first aspect, and at least two drivers connected in parallel to respective conducting tracks of each folded light engine. Such a lighting device may further comprise a controller configured to apply a different drive signal to each drive signal line, wherein each drive signal is time varying so as to cause a time variation of at least one property of light emitted from the LED light sources.

The properties of emitted light that change over time as a result of the varying drive signals may include color and/or intensity. Color changes may include changing non-white colors, but may also be restricted to varying the shade(s) (color temperature) of white.

The waveforms (i.e. patterns of change) of the different drive signals may be continuous, i.e. without discrete change, or involve step-wise change (e.g. sparkle). The waveforms of the drive signals may further have varying rate of change, and/or include linear ramps. The waveforms may be regular and periodic, or may change over time.

Each drive signal may have a common waveform but with a different offset in time. As a simple example, three sine-shaped drive signals can be phase-shifted to produce three different drive signals with the same waveform (sine-shaped).

The drive signals may include variations on a relatively shorter time scale and variations on a relatively longer time scale variation. Variations on different time scales (i.e. with different time constants) may be used to represent e.g. the long rhythm of a day and the faster rhythm of tree leaves moving in the wind.

It is noted that the invention relates to all possible combinations of features recited in the claims.

### BRIEF DESCRIPTION OF THE DRAWINGS

This and other aspects of the present invention will now be described in more detail, with reference to the appended drawings showing embodiment(s) of the invention.
Fig. 1 shows schematically a distribution of LED light sources of three LED chains.
Fig. 2 shows an arrangement including a lighting device with a single LED array, according to an embodiment of the present invention.
Fig. 3 shows an arrangement including a plurality of lighting devices according to an embodiment of the present invention.
Figs. 4a-d show schematically manufacture of a folded lighting device according to an embodiment of the present invention.
Fig. 5 shows a folded lighting device with three rows of LEDs.
Fig. 6 shows a device with three folded lighting devices according to a further embodiment of the invention.
Figs. 7a-c show schematically manufacture of a device with three folded lighting devices according to yet another embodiment of the present invention.

### DETAILED DESCRIPTION OF CURRENTLY PREFERRED EMBODIMENTS

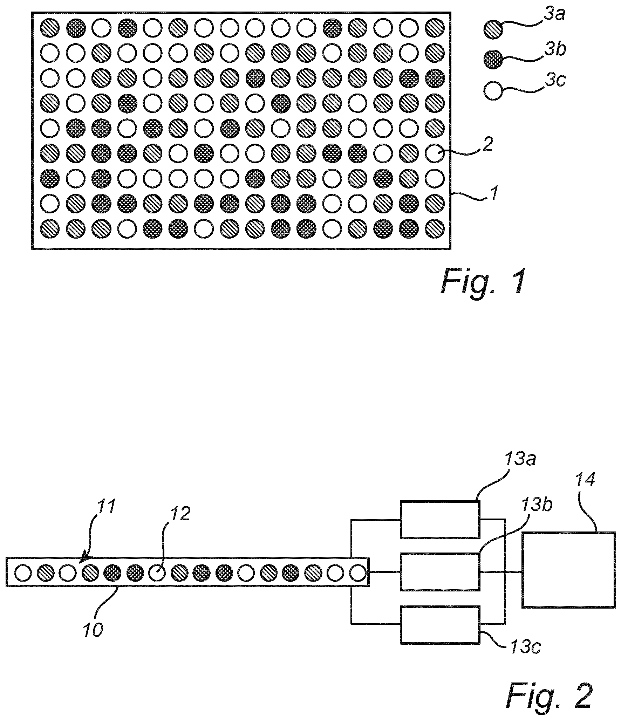

Figure 1 shows a light area 1 comprising of an array of 9 x 16 pixels 2. Three non-pixelated LED chains 3a, 3b, 3c, each including 48 LED light sources (nodes) 4 have been deployed to address all the pixels 2 in the array. The assignment of each pixel 2 to a node 4 in a given LED string (3a, 3b or 3c) is random (i.e. not systematic), and as a result the nodes 4 of each LED chain are spread out substantially evenly (similar sparsity) across the entire area in a non-symmetrical (or non-regular) manner. The randomized positions of the light sources 4 in figure 1 can for example be routed onto a PCB, with the electric tracks providing the intended allocation of each pixel to a given LED chain.

The distribution of pixels (i.e. possible locations of light nodes) may be regular (e.g. a rectangular grid) or irregular (e.g. Voronoi, polygonal or hexagonal arrays). The distribution may further exhibit gradients and/or local variation in density (the number of light nodes per area temporarily increases and/or decreases) with the local density variation being either uniform and/or non-uniform in nature (e.g. mix of coarse and fine meshes).

Figure 2 shows a light engine 10, including a linear array 11 of LED light sources 12, belonging to a plurality (here three) randomly nested LED chains. The three LED chains are each connected to a LED chain driver 13a, 13b, 13c, which each driver being configured to generate drive waveforms. All LED light sources (nodes) 12 of a particular LED chain are driven by the same drive waveform(s).

The drivers 13a, 13b, 13c are in turn connected to a controller 14 arranged to control the light emission of all LED chains in the light engine 10. The controller 14 may be a microcontroller running a suitable control program. The controller 14 (e.g. the computer program running on a microcontroller) and the drivers are together capable of providing a well-controlled natural light effect, comprising transitions between different intensities, colors, hue, frame rate, etc. The randomized assignment of light source location enables change of scene and content while maintaining a natural and non-looped experience.

Each driver 13a-c may be controlled to provide a unique waveform, Alternatively, the output from one single driver (waveform generator) is time shifted to provide a set of different drive signals for driving a set of LED chains differently.

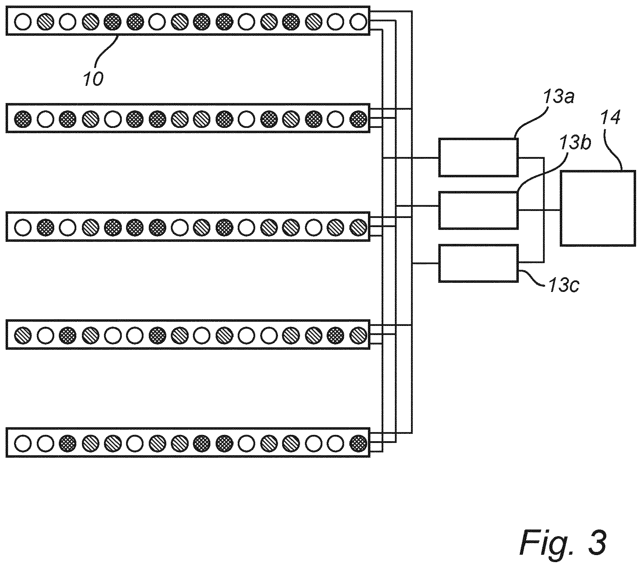

By arranging a plurality of light engines10 in parallel (each with a unique random nesting of LED chains), a larger light area as shown in figure 1 may be obtained. In principle, each light engine 10 could be provided with individual controllers 13a-c as shown in figure 2. Alternatively, and as shown in figure 3, the drivers 13a-c are connected in parallel to a plurality of light engines 10 (figure 3 shows five light engines).

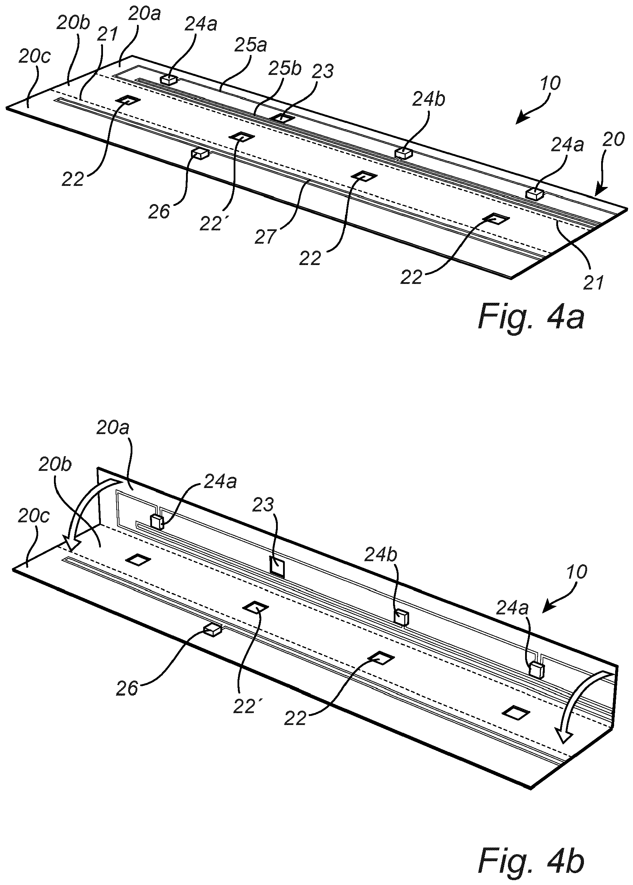

Figure 4a-4d illustrates how a folded light engine 10 may be manufactured from a single, flexible, elongated substrate strip 20. The substrate 20 may for example be made of a foil material kept on a roll. The substrate is further configured to allow printing of circuit tracks and surface mounting of electrical components. The substrate strip 20 comprises a plurality, here three, parallel and equally wide portions 20a, 20b, 20c extending along the entire length of the substrate. The portions 20a-c may be separated by perforations or folding lines 21, to facilitate folding as will be discussed below. The substrate portions 20a-c may generally have optical properties suitable for a specific application, and may for example be (semi-) transparent, colored, diffuse, reflective or structured. The substrate may be co-extruded, allowing different portions to have different properties. For example, the substrate may have a light transparent central portion 20b, and a reflective peripheral portion 20a.

The center portion 20b is further provided with a first set of through-holes 22. In the illustrated example, the through holes 22, 22' are equidistantly distributed along the portion 20b. The function of the through-holes 22, 22' will be discussed in more detail below. However, in addition to their function in the light engine 10, the through holes 22, 22' may also be useful in the manufacturing process, and may serve to allow a chain-paper-type controlled guidance of the substrate.

The first peripheral portions, here portion 20a, is provided with a second set of through-holes 23, fewer in number than the through holes 22. In the illustrated case, the first set includes four through holes 22, 22', while the second set includes only one through-hole 23.

A first group of LEDs 24a, 24b are mounted on the first peripheral portion, and connected by electrically conducting tracks 25a, 25b. In the illustrated case, the first group of LEDs includes two sub-groups of LEDs 24a and 24b, each connected by separate tracks 25a and 25b. The two sub-groups thus form two LED-chains which may be individually controllable by different drive signals.

In a similar manner, a second group of LEDs 26 are mounted on the second peripheral portion 20c, and connected by electrically conducting tracks 27. This second group of LEDs 26 forms a third LED-chain, individually controllable by a different drive signal than the first group of LEDs 24a, 24b.

In practice, it may be advantageous to first provide the circuit tracks 25a, 25b and 27 in a circuit patterning process. The tracks preferably include connection pads (solder pads) in the location where the LEDs 24a, 24b and 26 are to be mounted. Then, when the tracks have been printed, the LEDs 24a, 24b, 26 are mounted in a surface mounting process. It is noted that the circuit patterning and surface mounting processes are facilitated by the fact that all tracks and LEDs are located on the same side of the substrate 20.

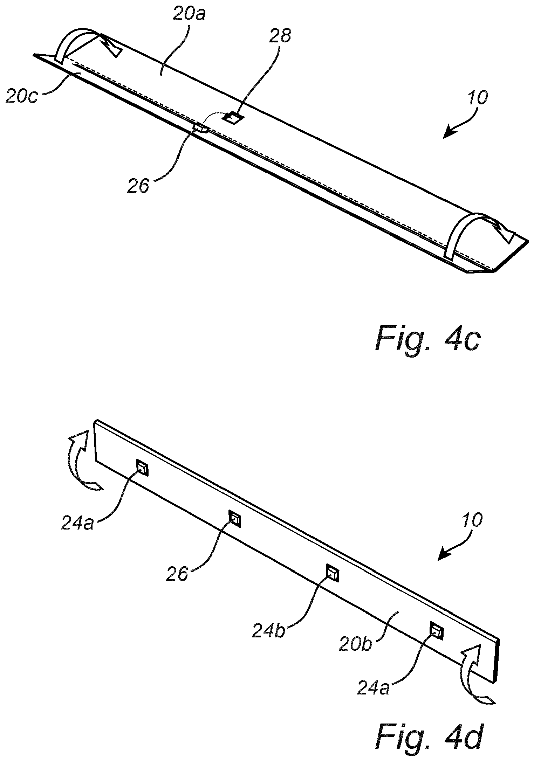

The holes 23 and LEDs 24a, 24b in the first peripheral portion 20b are aligned with the holes 22, 22' in the center portion, such that, when the first peripheral portion 20a is folded over the center portion 20b, as shown in figure 4b, the holes 23 and LEDs 24a, 24b will each coincide with one of the holes 22, 22'. Further, the LEDs 26 on the second peripheral portion 20c (here only one) are aligned with the holes 23 in the first peripheral portion 20a, such that, when the second peripheral portion 20c is folded over the center portion 20b and the first peripheral portion 20a, as shown in figure 4c, the LEDs 26 will each coincide with a combined hole 28 formed by a through-hole 22' in the central portion 20b and a through-hole 23 in the first peripheral portion 20a.

When both peripheral portions 20a, 20c have been folded over the central portion 20b, all LEDs 24a, 24b, 26 will thus be visible from the other side of the light engine 10, as shown in figure 4d. The separate tracks 25a, 25b and 27, and their respective nested LED-chains, may now be connected to different drive signals, e.g. by means of drivers 13a-c as shown in figure 2.

In the folded state of the light engine 10, the LEDs 24a, 24b, 26 will be protected by the folded portions 20a, 20b, 20c of the substrate, preventing electrical and mechanical access. To even further enhance this effect, the substrate portions 20a-c are preferably attached and sealed to each other, at least locally. Sealing may be achieved in various ways, including adhesive or spot-welding. Alternatively, the substrate is formed of a heat-sealable foil, allowing the folded light engine 10 to be heat-sealed.

Although not shown in figure 4a-d, an additional sealing portion may be provided along the outside the second peripheral portion 20c, and be folded around the folded light engine onto the backside of the central portion. Such a sealing portion may be formed by the same (non-transparent) substrate as the other portions 20a-c, in which case it preferably is sufficiently narrow so that it will not obstruct the LEDs in the through holes.

Another alternative is to form this sealing portion of a light transparent foil, in which it can extend over the through holes and the LEDs thereunder, so as to shield the LEDs from direct/mechanical access, to prevent debris and contaminants to reach the LEDs and circuit tracks, or simply to provide a water tight barrier/envelope. Such a transparent foil may be co-extruded and form part of the substrate 20, or be formed as a separate piece.

The transparent foil may be wide enough to extend fully around the folded light engine, thus providing a fully sealed envelope around the light engine. In fact, such a transparent foil may extend more than one turn around the light engine, to even further increase the protective effect. In this case, however, the foil is preferably provided with through holes matching the holes 22, 22', 23 in each layer except the final layer. This is because each layer causes some Fresnel reflection at the foil's surface, resulting in a reduced light output when compared to no covering foil.

The total number of LEDs 24a, 24b, 26 corresponds to the number of holes 22, 22' in the first set of through-holes, so four in this case. In reality, there would typically be a larger number of holes 22, 22', e.g. more than 10, more than 20, or even more than 50, and a corresponding number of LEDs 24a, 24b, 26.

Each separate LED-chain preferably includes roughly the same number of LEDs. In the illustrated example, where the first peripheral portion 20a comprises two separate chains of LEDs 24a, 24b, the number of holes 23 in the first peripheral portion 20a, and thus the number of LEDs 26 on the second peripheral portion 20c, is preferably around one third of the number of holes 22, 22' (or, put differently, around half of the number of LEDs 24a, 24b on the first peripheral portion 20a).

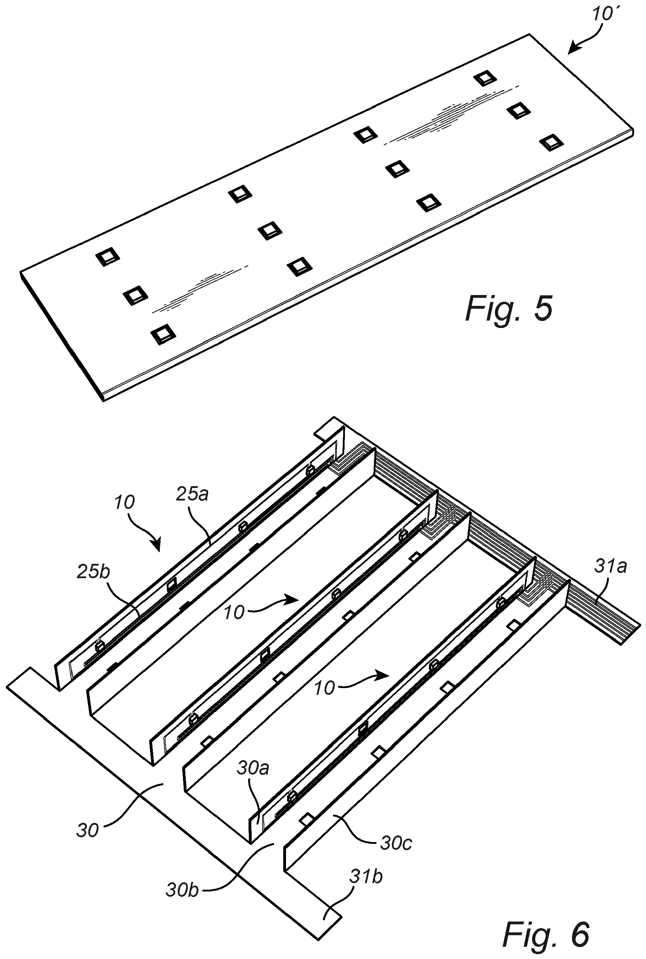

In figures 4a-d the central portion 20b has one single row of holes 22, 22', and the complete light engine thus has one single row of LEDs 24a, 24b, 26. It is noted that the central portion may equally well have several (e.g. three) rows of holes 22, 22', and the LEDs 24a, 24b, 26 may be aligned with holes in all rows. Figure 5 gives an example of a lighting device manufactured according to the principles of figures 4a-d, but with three rows of LEDs.

With reference to figure 6, several lighting devices 10 arranged in parallel may be manufactured from one single substrate 30. As shown in figure 6, the substrate 30 here has three sets of parallel portions 30a, 30b, 30c, each corresponding to the portions 20a, 20b, 20c in figure 4a, to allow forming three lighting devices 10. The three central portions 30b are connected in their respective ends by two transversal portions 31a, 31b, to form a ladder-like shape. One of the transversal portions 30a is provided with printed circuit tracks 35 connecting the tracks 25a, 25b, 27 (27 is not shown in figure 6) on the respective devices 10 in parallel. Three drive signals may now be connected to all lighting devices together, e.g. by connecting three drivers 13a-c as shown in figure 3.

When the light engine 10 is intended to be used in a lighting device as discussed in the application titled "Lighting device for providing a natural lighting effect" filed on the same date as the present application, the distribution of LEDs, i.e. the nesting of the separate LED-chains, is irregular, or randomized. In other words, each light engines 10 in figure 6 will have a unique distribution of LEDs, and the plurality of light engines 10 will form a light area having three nested LED-chains with LEDs substantially evenly and non-symmetrically distributed over the light area.

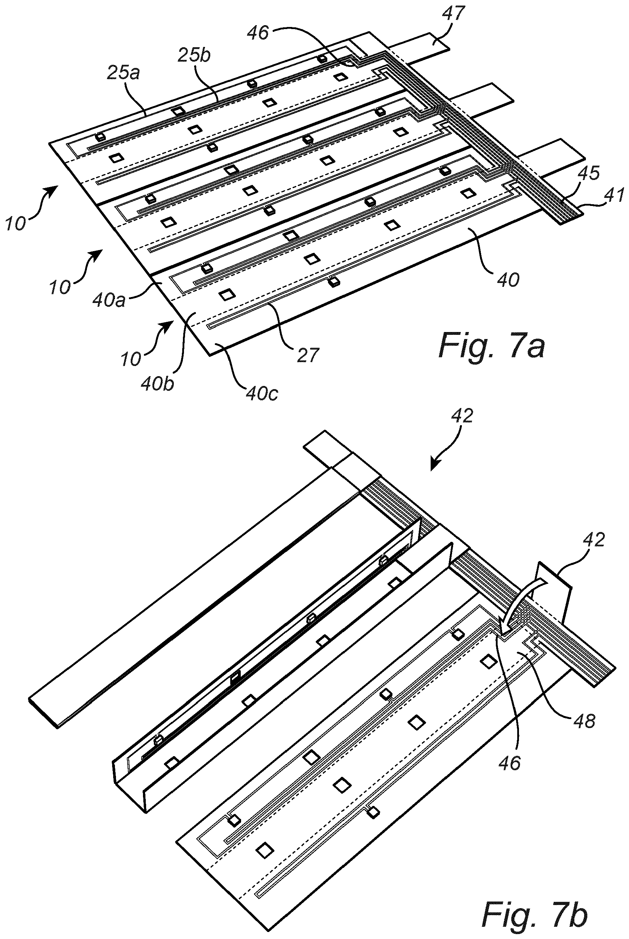

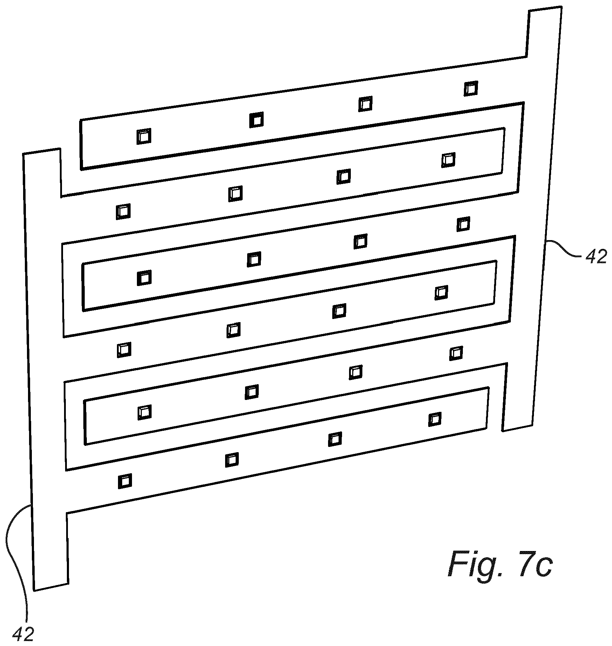

Figures 7a-7c show a further example of manufacturing a plurality of lighting devices 10 from a single substrate. Similar to the substrate in figure 6, the substrate 40 in figure 7a includes three sets of parallel portions 40a, 40b, 40c. In this case, however, the center portions 40b are connected by a transversal portion 41 only on one side, so as to form a device 42 in the shape of a fork when folded, as shown in figure 7b. Similar to figure 6, the transversal portion 41 is provided with printed circuit tracks 45 connecting the tracks 25a, 25b, 27 on the respective devices 10 in parallel. In the illustrated example, the central portions 40b are provided with circuit tracks 46 which connect the tracks 45 on the transversal portion with the tracks 25a, 25b and 27. As shown in figure 7c, two forks 42, each with a plurality of lighting devices 10, may be interleaved.

The substrate 40 is further provided with flaps 47, extending from the transversal portion 41, and located opposite of each central portion 40b. As shown in figure 7b, the flaps 46 are folded over the end 48 of the central portions 40b, before the peripheral portions 40a, 40c are folded over the central portion 40b. The flaps 47 serve to isolate circuit tracks 46 on the central portion 40b, and to avoid any short-circuit caused when folding the peripheral portions 40a, 40c. It is noted that such flaps 47 may be provided also in the embodiments in the previous figures.

The person skilled in the art realizes that the present invention by no means is limited to the preferred embodiments described above. On the contrary, many modifications and variations are possible within the scope of the appended claims. For example, the appropriate number of LED chains in each group may be different. Further, the density of the LED chain or group of LED chains may be either uniform or non-uniform for a portion of a light area.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A folded light engine comprising an array of LEDs mounted on a strip substrate, wherein
the strip substrate comprises a central portion (20b) and first and second peripheral portions (20a, 20c) of substantially equal width and extending in parallel in the longitudinal direction of the strip substrate,
the central portion (20b) being provided with a first set of through-holes (22, 22'),
the first peripheral portion (20a) being provided with at least one electrically conducting track (25a, 25b), connecting a first group of LEDs (24a, 24b) mounted on the first peripheral portion, each LED (24a, 24b) in the first group being aligned with a through-hole (22) in the central portion,
the first peripheral portion (20a) further being provided with a second set of through holes (23), each through-hole in the second set being aligned with a through-hole (22') in the first set,
the second peripheral portion (20c) being provided with at least one electrically conducting track (27), connecting a second group of LEDs (26) mounted on the second peripheral portion, each LED (26) in the second group being aligned with a through-hole (22') in the first set and with a through-hole (23) in the second set,
wherein the first peripheral portion (20a) has been folded over the central portion (20b), so that the LEDs mounted on the first peripheral portion coincide with through-holes in the central portion, and through-holes in the first peripheral portion coincide with corresponding through-holes in the central portion, and
wherein the second peripheral portion (20c) has been folded over the first peripheral portion (20a), so that LEDs (26) mounted on the second peripheral portion coincide with a combined through-hole (28) formed by a through-hole (22') in the central portion and a through-hole (23) in the first peripheral portion.

2. The folded light engine according to claim 1, wherein the first peripheral portion (20a) is provided with two separate electrically conducting tacks (25a, 25b), each connecting one sub-group of LEDs (24a, 24b) in the first group.

3. The folded light engine according to claim 1, wherein surfaces of the central portion and surfaces of the first and second peripheral portions are attached to each other after folding.

4. The folded light engine according to claim 1 or 2, further comprising an additional peripheral portion, located outside the second peripheral portion, said additional peripheral portion being configured to be folded onto the backside of the central portion.

5. The folded light engine according to one of the preceding claims, wherein a protecting sleeve is arranged around the folded substrate.

6. The folded light engine according to claim 5, wherein said protective sleeve is formed by a light transparent foil, wrapped around the folded light engine.

7. The folded light engine according to claim 5 or 6, wherein a space between the protecting sleeve and the folded substrate is filled with a curable filler.

8. A multi-light-engine device, comprising a plurality of light engines according to any one of the preceding claims, said light engines being formed on one common substrate, said common substrate further comprising a transversal portion (31a, 41) connecting respective ends of the central portions of each light engine.

9. The multi-light-engine device according to claim 8, wherein said transversal portion further is provided with electrically conductive tracks (45), connecting the tracks (25a, 25b, 27) of the respective light engines in parallel.

10. The multi-light-engine device according to claim 9, wherein the substrate further comprises flaps (47) extending from the transversal portion and located opposite of each central portion (40b), said flaps (47) being folded over the respective central portion (40b) so as to prevent short-circuit.

11. A lighting device comprising at least one folded light engine (10) according to any one of claims 1 to 7, and at least two drivers connected in parallel to respective conducting tracks (25a, 25b, 27) of each folded light engine (10).

12. The lighting device according to claim 11, further comprising a controller configured to apply a different drive signal to each drive signal line, wherein each drive signal is time varying so as to cause a time variation of at least one property of light emitted from the LED light sources.

13. The lighting device according to claim 11 or 12, comprising at least two multi-light-engine devices according to one of claims 8 - 10, said multi-light-engine devices each having a shape of a fork, and the light engines of one multi-light-engine device being interleaved with the light engines of another multi-light-engine device.

## Patentansprüche

1. Zusammengeklappte Lichtmaschine, umfassend eine Anordnung von LEDs, die auf einem Streifensubstrat montiert sind, wobei
das Streifensubstrat einen Mittelabschnitt (20b) und einen ersten und einen zweiten Umfangsabschnitt (20a, 20c) von im Wesentlichen gleicher Breite umfasst und sich parallel in der Längsrichtung des Streifensubstrats erstreckt,
wobei der Mittelabschnitt (20b) mit einem ersten Satz von Durchgangslöchern (22, 22') versehen ist,
wobei der erste Umfangsabschnitt (20a) mit mindestens einer elektrisch leitenden Schiene (25a, 25b) versehen ist, die eine erste Gruppe von LEDs (24a, 24b) verbindet, die auf dem ersten Umfangsabschnitt montiert ist, wobei jede LED (24a, 24b) in der ersten Gruppe mit einem Durchgangsloch (22) in dem Mittelabschnitt ausgerichtet ist,
wobei der erste Umfangsabschnitt (20a) ferner mit einem zweiten Satz von Durchgangslöchern (23) versehen ist, wobei jedes Durchgangsloch in dem zweiten Satz mit einem Durchgangsloch (22') in dem ersten Satz ausgerichtet ist,
wobei der zweite Umfangsabschnitt (20c) mit mindestens einer elektrisch leitenden Schiene (27) versehen ist, die eine zweite Gruppe von LEDs (26) verbindet, die auf dem zweiten Umfangsabschnitt montiert ist, wobei jede LED (26) in der zweiten Gruppe mit einem Durchgangsloch (22') in dem ersten Satz und mit einem Durchgangsloch (23) in dem zweiten Satz ausgerichtet ist,
wobei der erste Umfangsabschnitt (20a) über den Mittelabschnitt (20b) geklappt wurde, sodass die LEDs, die auf dem ersten Umfangsabschnitt montiert sind, mit Durchgangslöchern in dem Mittelabschnitt zusammenfallen, und Durchgangslöcher in dem ersten Umfangsabschnitt mit entsprechenden Durchgangslöchern in dem Mittelabschnitt zusammenfallen, und
wobei der zweite Umfangsabschnitt (20c) über den ersten Umfangsabschnitt (20a) geklappt wurde, sodass LEDs (26), die auf dem zweiten Umfangsabschnitt montiert sind, mit einem kombinierten Durchgangsloch (28) zusammenfallen, das durch ein Durchgangsloch (22') in dem Mittelabschnitt und ein Durchgangsloch (23) in dem ersten Umfangsabschnitt gebildet wird.

2. Zusammengeklappte Lichtmaschine nach Anspruch 1, wobei der erste Umfangsabschnitt (20a) mit zwei separaten elektrisch leitenden Schienen (25a, 25b) versehen ist, die jeweils eine Untergruppe von LEDs (24a, 24b) in der ersten Gruppe verbinden.

3. Zusammengeklappte Lichtmaschine nach Anspruch 1, wobei Oberflächen des Mittelabschnitts und Oberflächen des ersten und des zweiten Umfangsabschnitts nach dem Zusammenklappen aneinander angebracht sind.

4. Zusammengeklappte Lichtmaschine nach Anspruch 1 oder 2, ferner umfassend einen zusätzlichen Umfangsabschnitt, der sich außerhalb des zweiten Umfangsabschnitts befindet, wobei der zusätzliche Umfangsabschnitt konfiguriert ist, um auf die Rückseite des Mittelabschnitts geklappt zu werden.

5. Zusammengeklappte Lichtmaschine nach einem der vorstehenden Ansprüche, wobei eine Schutzhülse um das gefaltete Substrat herum angeordnet ist.

6. Zusammengeklappte Lichtmaschine nach Anspruch 5, wobei die Schutzhülse durch eine lichttransparente Folie gebildet ist, die um die zusammengeklappte Lichtmaschine herum gewickelt ist.

7. Zusammengeklappte Lichtmaschine nach Anspruch 5 oder 6, wobei ein Raum zwischen der Schutzhülse und dem zusammengeklappten Substrat mit einem härtbaren Füllstoff gefüllt ist.

8. Mehrlichtmaschinenvorrichtung, umfassend eine Vielzahl von Lichtmaschinen nach einem der vorstehenden Ansprüche, wobei die Lichtmaschinen auf einem gemeinsamen Substrat gebildet sind, das gemeinsame Substrat ferner umfassend einen Querabschnitt (31a, 41), der jeweilige Enden der Mittelabschnitte jeder Lichtmaschine verbindet.

9. Mehrlichtmaschinenvorrichtung nach Anspruch 8, wobei der Querabschnitt ferner mit elektrisch leitenden Scheinen (45) versehen ist, die die Schienen (25a, 25b, 27) der jeweiligen Lichtmaschinen parallel schalten.

10. Mehrlichtmaschinenvorrichtung nach Anspruch 9, wobei das Substrat ferner Klappen (47) umfasst, die sich von dem Querabschnitt erstrecken und sich gegenüber von jedem Mittelabschnitt (40b) befinden, wobei die Klappen (47) über den jeweiligen Mittelabschnitt (40b) geklappt werden, um einen Kurzschluss zu verhindern.

11. Beleuchtungsvorrichtung, umfassend mindestens eine zusammengeklappte Lichtmaschine (10) nach einem der Ansprüche 1 bis 7 und mindestens zwei Steuerglieder, die mit jeweiligen leitenden Schienen (25a, 25b, 27) jeder zusammengeklappten Lichtmaschine (10) parallel geschaltet sind.

12. Beleuchtungsvorrichtung nach Anspruch 11, ferner umfassend eine Steuerung, die konfiguriert ist, um ein unterschiedliches Ansteuersignal an jede Ansteuersignalleitung anzulegen, wobei jedes Ansteuersignal zeitlich variiert, um eine Zeitvariation von mindestens einer Eigenschaft von Licht zu bewirken, das von den LED-Lichtquellen emittiert wird.

13. Beleuchtungsvorrichtung nach Anspruch 11 oder 12, umfassend mindestens zwei Mehrlichtmaschinenvorrichtungen nach einem der Ansprüche 8 bis 10, wobei die Mehrlichtmaschinenvorrichtungen jeweils eine Form einer Gabel aufweisen und die Lichtmaschinen einer Mehrlichtmaschinenvorrichtung mit den Lichtmaschinen einer anderen Mehrlichtmaschinenvorrichtung verschachtelt sind.

## Revendications

1. Moteur de lumière plié comprenant un réseau de DEL montées sur un substrat de bande, dans lequel
le substrat de bande comprend une partie centrale (20b) et une première et une seconde partie périphérique (20a, 20c) de largeur sensiblement égale et s'étendant parallèlement dans la direction longitudinale du substrat de bande,
la partie centrale (20b) étant pourvue d'un premier ensemble de trous traversants (22, 22'),
la première partie périphérique (20a) étant pourvue d'au moins une piste électroconductrice (25a, 25b) connectant un premier groupe de DEL (24a, 24b) montées sur la première partie périphérique, chaque DEL (24a, 24b) dans le premier groupe étant alignée sur un trou traversant (22) dans la partie centrale,
la première partie périphérique (20a) étant en outre pourvue d'un second ensemble de trous traversants (23), chaque trou traversant dans le second ensemble étant aligné sur un trou traversant (22') dans le premier ensemble,
la seconde partie périphérique (20c) étant pourvue d'au moins une piste électroconductrice (27) connectant un second groupe de DEL (26) montées sur la seconde partie périphérique, chaque DEL (26) dans le second groupe étant alignée sur un trou traversant (22') dans le premier ensemble et sur un trou traversant (23) dans le second ensemble,
dans lequel la première partie périphérique (20a) a été pliée au-dessus de la partie centrale (20b) de sorte que les DEL montées sur la première partie périphérique coïncident avec des trous traversants dans la partie centrale, et que des trous traversants dans la première partie périphérique coïncident avec des trous traversants correspondants dans la partie centrale, et
dans lequel la seconde partie périphérique (20c) a été pliée au-dessus de la première partie périphérique (20a) de sorte que des DEL (26) montées sur la seconde partie périphérique coïncident avec un trou traversant combiné (28) formé par un trou traversant (22') dans la partie centrale et un trou traversant (23) dans la première partie périphérique.

2. Moteur de lumière plié selon la revendication 1, dans lequel la première partie périphérique (20a) est pourvue de deux pistes électroconductrices (25a, 25b) distinctes, chacune connectant respectivement un sous-groupe de DEL (24a, 24b) dans le premier groupe.

3. Moteur de lumière plié selon la revendication 1, dans lequel des surfaces de la partie centrale et des surfaces de la première et de la seconde partie périphérique sont fixées les unes aux autres après pliage.

4. Moteur de lumière plié selon la revendication 1 ou 2, comprenant en outre une partie périphérique supplémentaire située à l'extérieur de la seconde partie périphérique, ladite partie périphérique supplémentaire étant conçue pour être pliée sur la face arrière de la partie centrale.

5. Moteur de lumière plié selon l'une des revendications précédentes, dans lequel une gaine de protection est agencée autour du substrat plié.

6. Moteur de lumière plié selon la revendication 5, dans lequel ladite gaine de protection est formée par une feuille transparente à la lumière et enroulée autour du moteur de lumière plié.

7. Moteur de lumière plié selon la revendication 5 ou 6, dans lequel un espace entre la gaine de protection et le substrat plié est rempli d'une charge durcissable.

8. Dispositif à multi-moteurs de lumière, comprenant une pluralité de moteurs de lumière selon l'une quelconque des revendications précédentes, lesdits moteurs de lumière étant formés sur un substrat commun, ledit substrat commun comprenant en outre une partie transversale (31a, 41) reliant des extrémités respectives des parties centrales de chaque moteur de lumière.

9. Dispositif à multi-moteurs de lumière selon la revendication 8, dans lequel ladite partie transversale est en outre pourvue de pistes électroconductrices (45) connectant en parallèle les pistes (25a, 25b, 27) des moteurs de lumière respectifs.

10. Dispositif à multi-moteurs de lumière selon la revendication 9, dans lequel le substrat comprend en outre des pattes (47) s'étendant à partir de la partie transversale et situées à l'opposé de chaque partie centrale (40b), lesdites pattes (47) étant pliées au-dessus de la partie centrale (40b) respective de manière à empêcher un court-circuit.

11. Dispositif d'éclairage comprenant au moins un moteur de lumière plié (10) selon l'une quelconque des revendications 1 à 7 et au moins deux pilotes connectés en parallèle à des pistes conductrices (25a, 25b, 27) respectives de chaque moteur de lumière plié (10).

12. Dispositif d'éclairage selon la revendication 11, comprenant en outre une unité de commande configurée pour appliquer un signal d'entraînement différent à chaque ligne de signal d'entraînement, dans lequel chaque signal d'entraînement est variable dans le temps de manière à provoquer une variation temporelle d'au moins une propriété de la lumière émise à partir des sources de lumière à DEL.

13. Dispositif d'éclairage selon la revendication 11 ou 12, comprenant au moins deux dispositifs à multi-moteurs de lumière selon l'une des revendications 8 à 10, lesdits dispositifs à multi-moteurs de lumière ayant chacun une forme de fourche, et les moteurs de lumière d'un dispositif à multi-moteurs de lumière étant entrelacés avec les moteurs de lumière d'un autre dispositif à multi-moteurs de lumière.
